(19) Europäisches Patentamt

European Patent Office

Office européen des brevets

(11) EP 0 726 530 B1

(12) EUROPEAN PATENT SPECIFICATION

(45) Date of publication and mention
of the grant of the patent:
30.08.2000 Bulletin 2000/35

(51) Int Cl.[7]: **G06F 15/80**, G11C 11/54

(21) Application number: 96101766.2

(22) Date of filing: 07.02.1996

(54) **Associative memory using DNA**

DNS-basierter inhaltsadressierbarer Speicher

Mémoire associative utilisant l'ADN

(84) Designated Contracting States:
**DE FR GB**

(30) Priority: 07.02.1995 US 384995

(43) Date of publication of application:
**14.08.1996 Bulletin 1996/33**

(73) Proprietor: **NEC CORPORATION**
**Tokyo (JP)**

(72) Inventor: **Baum, Eric Burton**
**Princeton, N.J. 08540 (US)**

(74) Representative: **Betten & Resch**
**Reichenbachstrasse 19**
**80469 München (DE)**

(56) References cited:
**WO-A-87/01807**

• **SCIENCE, vol. 268, 28 April 1995 LONDON , GB, pages 583-585, BAUM 'Building an associative memory vastly larger than the brain'**
• **1978 INTERNATIONAL MAGNETICS CONFERENCE, FLORENCE, ITALY, 9-12 MAY 1978, vol. MAG-14, no. 5, ISSN 0018-9464, IEEE TRANSACTIONS ON MAGNETICS, SEPT. 1978, USA, pages 964-965, BATE G 'Bits and genes: a comparison of the natural storage of information in DNA and digital magnetic recording'**
• **JOURNAL OF PHYSICS D. APPLIED PHYSICS, vol. 22, no. 11, 14 November 1989 pages 1571-1579, XP 000072956 CHIABRERA A ET AL 'PHYSICAL LIMITS OF INTEGRATION AND INFORMATION PROCESSING IN MOLECULAR SYSTEMS'**
• **ELEKTRONIK, vol. 34, no. 13, June 1985 MUNCHEN , DE, pages 65-69, NOLDECHEN 'Biochips: die Zukunft im Visier'**

## Description

Field of the Invention

The present invention relates to associative memories and particularly to the use of DNA for forming associative memories.

Background of the Invention

The use of the tools of molecular biology to solve computer science problems, such as the directed Hamiltonian path problem, has been proposed in an article by L.M. Adleman entitled "Molecular Computation of Solutions to Combinatorial Problems" in Science, vol. 266, pp. 1021 to 1024 (1994).

The solution of the Hamiltonian path problem is any path that starts and ends at specified vertices and enters every other vertex exactly once. Adleman's method of solving the problem is to generate random paths through a directed graph of n vertices, with designated vertices Vin and Vout. Keep those paths (1) beginning at Vin and ending at Vout, (2) entering exactly n vertices and (3) only those entering each vertex at least once. Any paths remaining are the solution to the problem.

Adleman's implementation is to associate each vertex with a random 20-mer sequence of DNA. For each edge of the graph $i \rightarrow j$, create a 20-mer sequence, designated $O_{i \rightarrow j}$, comprising the last 10-mer of the i vertex and the first 10-mer of the j vertex. In the case of Vin and Vout, the entire 20-mer is used to designate the requisite vertex, i.e. a 30-mer sequence will be created.

In order to implement the method, the sequence (designated $\overline{O}_i$) of DNA Watson-Crick complementary to the sequence for the vertex i and the sequence $O_{i \rightarrow j}$ for all i,j on the graph are mixed. The edge sequences $O_{i \rightarrow j}$ serve as splints for the vertex sequences $\overline{O}_i$, thereby producing molecules corresponding to random paths through the graph.

The result was amplified by PCR (polymerase chain reaction) using primer $O_0$ and $\overline{O}_6$ where $V_0$ is Vin and $V_6$ is vertex Vout. That is, only those DNA molecules encoding paths beginning at vertex Vin and ending at vertex Vout were amplified.

The remaining molecules were pulled through an agarose gel by electrophoresis. This step allows the measurement of the molecular length. Only those molecules of the proper length were kept.

The remaining double strand DNA was split into single strand and a "Separate" operation was performed. The separate operation comprises the steps of taking sequence $\overline{O}_i$ and affixing a magnetic bead to the sequence. Placing these molecules in the test tube where they will bind with molecules containing $\overline{O}_i$, i.e., coding for paths containing vertex i. These bound molecules are then drawn off magnetically. This process is repeated for each vertex in the graph.

The result is amplified by PCR and electrophoresis in order to detect if any molecules are present. Any molecules present correspond to Hamiltonian paths. If no molecule is present, it would indicate no Hamiltonian path exists in the graph.

Subsequently, Lipton, in an article to be published, (presently available at /ftp/pub/people/rjl/bio.ps on ftp.cs.princeton.edu) provided a more practical algorithm. This approach is to extract from the test tube all sequences containing some predetermined set of consecutive sequences. Then, detect if there is any DNA in the test tube.

The present invention extends the above described tools to produce an associative memory of immense capabilities.

Summary of the Invention

An associative memory is a memory where words can be stored and then retrieved using only partial, or partially erroneous, information about their content (rather than needing to know a specific address).

The memory comprises a vessel or test tube containing DNA. A word is written into the memory by placing in the vessel an appropriate DNA molecule coding the word. A single DNA molecule encoding the word is sufficient. However, in practice, it is preferable to introduce many copies of the molecule encoding the word into the vessel. The words to be stored come from a virtual binary vector space of possibly high dimension. Each component in the vector space is represented by a specific short DNA sequence, for instance, 20 to 100 nucleotides long. The lengths used to code different components may vary. Employing shorter sequences for more commonly used word components results in a space efficient memory. Using different lengths for different subsequences will aid in recognition, since the length of a DNA molecule can readily be determined. A DNA molecule in the memory corresponds to a stored virtual vector having a "1" at all components for which the molecule has the corresponding subsequence and "0" elsewhere. Thus, relatively short DNA molecules can represent sparse vectors (i.e. containing few 1s) from a very large virtual vector space. It will be apparent to those skilled in the art, that in the following text, the roles of the "1"s and the "0"s can be reversed. Alternatively, each component number, component value pair can be associated with a specific DNA subsequence. In this case the "0"'s are coded explicitly as opposed to merely being implied by the absence of a subsequence encoding a "1". The DNA molecule coding a particular word is composed by concatenating the appropriate subsequences corresponding to its particular bits in any order.

The process of creating an associative memory using DNA comprises forming custom DNA molecules with appropriate subsequences in the molecule, placing the custom DNA molecules into a vessel, and searching the vessel for DNA molecules having the desired subsequences. After a DNA molecule is found which contains the desired subsequence, the remainder of the molecule is read out.

A principal object of the present invention is therefore, the provision of an associative memory using DNA.

Another object of the invention is the provision of a method of writing information into and reading information from an associative memory comprising DNA.

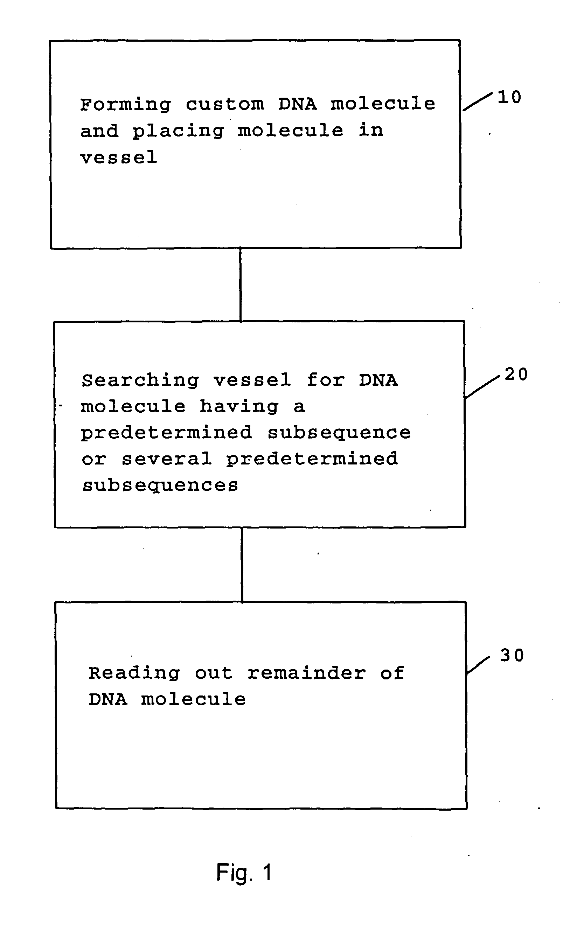

Further and still other objects of the present invention will become more clearly apparent when the following description is read in conjunction with the accompanying drawing.

Brief Description of the Drawing

The sole figure is a flow chart of a preferred method for implementing an associative memory using DNA.

Detailed Description of the Invention

Referring now to the sole figure in the present application, the first step 10 is to form a custom DNA molecule having predetermined subsequences and placing the molecule in a vessel or test tube. Preferably, the DNA molecule coding of a particular word is formed by concatenating predetermined subsequences corresponding to the particular bits, in any order.

The step of forming of subsequences corresponding to components may be accomplished in several ways. It is possible to form the subsequences by encoding the number of the component in the sequence followed by a distinctive "stop" sequence. The "stop" sequence is selected to be broken by a particular restriction enzyme, which facilitates chopping a DNA molecule into its component subsequences.

Also, instead of simply using a code for the location number, it is possible to use sequences selected to be unambiguously distinguishable using restriction mapping, which may facilitate reading of the information as described below. Restriction mapping is described in the book by B. Alberts et al, entitled "Molecular Biology of the Cell" published by Garland Publishing, New York, 1994.

Further alternative forming methods include using subsequences selected from an optimized code chosen to minimize recognition errors and using naturally occurring DNA fragments.

Current technology, as described in the book by Alberts et al, is such that automated oligonucleotide synthesizers can rapidly produce any DNA molecule containing up to about 100 nucleotides. These can be joined together by repeated DNA cloning steps in various combinations to produce long custom designed DNA molecules of any sequence. It is also possible to produce long DNA sequences even more facilely by linking selected naturally occurring segments.

Once the component subsequences have been created, they can be copied inexpensively. Writing words into the associative memory is relatively quick and inexpensive since test tubes can be maintained which already contain each previously formed component sequence. There may also be previously created sequences for use in splinting component subsequences together (see, for example, Adleman supra).

There is considerable latitude in choosing the DNA subsequences corresponding to components. The only constraint is that none of the subsequences is a subsequence of another component nor of two other concatenated subsequences, since this would lead to ambiguities in the recall process. Typically, subsequences having a length of between 10 and 100 nucleotides will suffice to avoid such ambiguity (depending upon memory size). It will sometimes be advantageous to end subsequence with a distinctive "stop" subsequence. The use of a stop subsequence will avoid ambiguities arising from concatenation, and if the stop sequence is chosen to be broken by a particular restriction enzyme, it will facilitate chopping a DNA molecule into its component subsequences.

If the complement of one sequence is not used to code for another sequence, then any complementary fragments which creep in during augmentation or reading will not corrupt the memory since the fragments will not be interpreted as stored words and can be readily removed.

If each component subsequence begins with a start sequence A and ends with a stop sequence B, the molecule $\bar{B}\bar{A}$ (i.e., the Watson-Crick complement of sequence B ligated to the complement of sequence A) will serve as a general purpose splint to join component subsequences in an order independent manner. Alternatively, it is possible to arrange to append subsequences in a predetermined order, using more specific splinting sequences.

After having formed custom DNA molecules and placing them in a vessel, such as a test tube, i.e. the writing step, it is necessary to be able to read the memory in a content addressable fashion by searching (step 20) the vessel for those DNA molecules having a predetermined DNA sequence or several predetermined sequences. The preferred method of searching the vessel, given a "cue" comprising a subset of the non-zero components of a word, is to extract all the DNA molecules containing the appropriate cue sequences. Alternatively, if there are no molecules in the vessel containing all the appropriate subsequences, it is possible to extract the molecules containing the most matches to obtain one or more best matches. It is also possible to search for some zero components. The DNA matches are culled for any molecules containing the corresponding subsequences, and these molecules are removed. The culling is accomplished with a separate diffusion step. The search is logically analogous to the search in a grandmother cell associative memory for any stored word containing a particular subset of bits, as described in an article by E.B. Baum et al entitled "Internal Representations for Associative Memory," Biological Cybernetics, v. 59, 1988, pp. 217 to 228.

There are several known processes in molecular biology which may be used to accomplish a search. A preferred search method is to use complementary sequences containing markers to search for subsequences. For each component specified in the cue, the complement of the corresponding subsequence of DNA, attached to a magnetic bead, is introduced into the vessel. These molecules will bond to the DNA molecules in the memory having the predetermined cue subsequence. These bonded molecules are then separated by diffusion. Such a procedure was described in the article by Adleman, supra. This procedure can be iterated sequentially for each component specified in the cue until only molecules coding for words consistent with the cue remain. Alternatively, the magnetically marked subsequences complementary to the subsequences corresponding to the component values specified in the cue can be introduced simultaneously. The most magnetic DNA molecule then codes for the word with the most components matching the cue. The search time is essentially independent of the number of stored words, since the chemistry is computationally "in parallel". Depending upon the retrieval technique, the search time may depend linearly on the number of components in the cue sequence.

If the cue is traversed sequentially, first finding all molecules consistent with the first component specified in the cue, and then finding the subsets of these molecules, consistent with the next specified component, the retrieval would require a number of biological operations equal to the number of specified components. If beads are affixed to all specified components simultaneously and the most magnetic is drawn off, only a single operation will be needed. The time necessary to perform magnetic separation will depend on the number of specified components.

It will be apparent to those skilled in the art that while magnetic beads and complementary sequences are preferred methods of searching, other marker systems would be successful in searching and seeking matching subsequences of DNA components in a molecule.

It should also be apparent that agitation or mixing of the vessel is advantageous in order to speed the process and to assure mixing of all the molecules.

After a DNA molecule is found which contains the cue components, the molecule is sequenced to read the remainder of the word stored in the molecule (step 30). This step is also logically analogous to the read operation in the grandmother cell memory. Given a partial cue, the remainder of the components in the stored word can be restored. As described in chapter 7 of the Alberts et al book, DNA molecules may be rapidly processed using a variety of techniques. The process may be expedited by an appropriate choice of component subsequences, e.g. selecting subsequences so that restriction mapping is non-ambiguously able to distinguish different components, or so that the molecules are readily chopped into components by a particular restriction enzyme. Optimal selection of component sequences results in identification of the logical content of a stored molecule much faster than sequencing an arbitrary DNA molecule.

A large number of restriction enzymes are known which cleave DNA molecules at particular locations. By subjecting a given DNA molecule to different restriction enzymes, the molecule is cleaved into pieces of different, but well defined lengths depending upon the sequence. The lengths of the segments then provide constraints on the sequence. Frequently, even in naturally occuring DNA, these constraints are sufficient to determine the sequence. This process is known as restriction mapping. In accordance with the present invention, it is only necessary to design sequences which can be readily distinguished one from another by the various lengths into which they are cleaved by various restriction enzymes.

In order to expedite reading and to store more information, it is possible to store DNA molecules comprising an address portion and a data portion. The address portion is created as described above and addressed by content. After retrieval, the data portion is sequenced and read. The information data portion can be identical or different from the information stored in the address portion. The coding of the address and data portion can be the same or different. Storing information in the data portions simply as a base four word while being compact, would require full sequencing technology to read.

It is also possible to attach to the stored molecules potentially long sequences containing more information. These additional sequences could not be addressed by their content as outlined above. However, once the molecule was retrieved, the additional sequences would be readable. For example, the component apparatus described above could be used simply as an address scheme for an ordinary RAM, and the additional stored sequences read as long words stored at these addresses.

In a conventional RAM, the full address must be supplied in order to read a word. If the present memory is used as a RAM, the read operation is simplified since it is possible to attach a bead only to DNA molecules coding for the word desired to be recalled. If the address sequences are chosen from an error correcting code, the process will be expedited and it will be less likely that accidental bonding of retrieval sequences bonded to beads will occur to molecules which only approximately match. Therefore, no other molecules will be removed from memory during the read operation, and it will be much simpler to restore the memory after reading to its pre-read state.

Standard database operations such as delete are also possible. To delete, for example, the appropriate molecules are removed from the database.

Using presently available technology the search operation described above using beads is performed on single strand DNA, while sequencing an restriction mapping are performed on double strand DNA. It is possible, albeit fairly slow, to transform DNA from double to single strand, and vice versa. To speed search and sequencing, it is possible to use an address portion of a DNA molecule which is single strand and a data portion of a DNA molecule which is double strand.

After the read operation, any DNA molecules removed must be reintroduced into the memory, so that stored words will not be lost. A preferred method of accomplishing the reintroduction is to split the molecules back into single strand DNA. The strands without beads attached are then attached to the strands to be reintroduced. Alternatively, it is possible to keep a copy of the entire memory, and return the copy after several read operations.

Using current technology, the read and write time is in the order of hours. However, there is no apparent fundamental limitation preventing achieving automated read and write operations on a molecular timescale. Moreover, once the information is enclosed in DNA, the entire vessel can be copied relatively easily by DNA replication. Likewise, the information in a plurality of vessels can be readily merged by physically mixing the contents of each vessel. A millimole of molecules each 200 bases long would weigh about 50g and hence, occupy approximately 1000 liters. Such a volume could contain $10^{20}$ words each encoding several thousands or several tens of thousands of bits.

While there has been described and illustrated a preferred embodiment of an associative memory using DNA molecules, it will be apparent to those skilled in the art that further modifications and variations are possible without deviating from the broad principle and spirit of the present invention.

**Claims**

1. A method of writing into and reading from an associative memory of DNA molecules comprising the steps of:

   forming custom DNA molecules coded with information;

   placing said custom DNA molecules in a vessel;

   searching said custom DNA molecules for those molecules having a predetermined subsequence and selecting said molecules having the predetermined subsequence; and

   reading out the selected DNA molecules.

2. A method of writing into and reading from an associative memory of DNA molecules as set forth in claim 1, where said forming custom DNA molecules comprises encoding components of a vector for a stored word which have a predetermined value.

3. A method of writing into and reading from an associative memory of DNA molecules as set forth in claim 2, where said encoding comprises concatenating subsequences corresponding to a vector having a predetermined value at a predetermined component.

4. A method of writing into and reading from an associative memory of DNA molecules as set forth in claim 2, where said encoding comprises selecting DNA subsequences containing optimized code.

5. A method of writing into and reading from an associative memory of DNA molecules as set forth in claim 2, where said encoding comprises selecting DNA subsequences chosen to be unambiguously distinguishable by restriction mapping.

6. A method of writing into and reading from an associative memory of DNA molecules as set forth in claim 2, where said encoding comprises selecting'naturally occuring DNA fragments.

7. A method of writing into and reading from an associative memory of DNA molecules as set forth in claim 2, where said encoding comprises appending a stop sequence to a sequence associated with a predetermined component of a vector having a predetermined value.

8. A method of writing into and reading from an associative memory of DNA molecules as set forth in claim 2, where said encoding comprises appending a start sequence and a stop sequence to a sequence associated with a predetermined component of a vector having a predetermined value.

9. A method of writing into and reading from an associative memory of DNA molecules as set forth in claim 2, where said predetermined value is selected from the group consisting of "1"s, "0"s, and "1"s and "0"s.

10. A method of writing into and reading from an associative memory of DNA molecules as set forth in one of claims 1 or 2, where said searching comprises marking predetermined subsequences of a DNA molecule and extracting marked molecules.

**11.** A method of writing into and reading from an associative memory of DNA molecules as set forth in claim 10, where said marking comprises associating magnetic beads and said extracting comprises magnetic separation.

**12.** A method of writing into and reading from an associative memory of DNA molecules as set forth in one of claims 1 or 2, where said searching comprises introducing DNA having a subsequence complementary to said predetermined subsequences.

**13.** An associative memory comprising:

custom DNA molecules coded with information, said molecules being disposed in a vessel;
means for searching said custom DNA molecules for those molecules having a predetermined subsequence; and
means for reading out those molecules having a predetermined subsequence.

**14.** An associative memory as set forth in claim 13, where said means for searching comprises introducing a marked DNA molecule with a sequence complementary to said predetermined subsequence.

**15.** An associative memory as set forth in claim 14, where said marker is a magnetic bead.

**16.** An associative memory as set forth in claim 13, where said coded information comprises an address portion and a data portion.

**17.** An associative memory as set forth in claim 13, where said means for reading comprises a restriction enzyme.

**Patentansprüche**

**1.** Verfahren zum Schreiben in einen und zum Lesen aus einem Assoziativspeicher aus DNA-Molekülen, mit den folgenden Schritten:

Bilden von kundenspezifischen DNA-Molekülen, die mit Informationen codiert sind;
Anordnen der kundenspezifischen DNA-Moleküle in einem Gefäß;
Durchsuchen der kundenspezifischen DNA-Moleküle nach jenen Molekülen, die eine vorgegebene Untersequenz besitzen, und Auswählen der Moleküle mit der vorgegebenen Untersequenz; und
Auslesen der ausgewählten DNA-Moleküle.

**2.** Verfahren zum Schreiben in einen und zum Lesen aus einem Assoziativspeicher aus DNA-Molekülen nach Anspruch 1, bei dem das Bilden der kundenspezifischen DNA-Moleküle das Codieren von Komponenten eines Vektors eines gespeicherten Wortes, die einen vorgegebenen Wert besitzen, umfaßt.

**3.** Verfahren zum Schreiben in einen und zum Lesen aus einem Assoziativspeicher aus DNA-Molekülen nach Anspruch 2, bei dem das Codieren das Verknüpfen von Untersequenzen, die einem Vektor entsprechen, der an einer vorgegebenen Komponente einen vorgegebenen Wert besitzt, umfaßt.

**4.** Verfahren zum Schreiben in einen und zum Lesen aus einem Assoziativspeicher aus DNA-Molekülen nach Anspruch 2, bei dem das Codieren das Auswählen von DNA-Untersequenzen, die einen optimierten Code enthalten, umfaßt.

**5.** Verfahren zum Schreiben in einen und zum Lesen aus einem Assoziativspeicher aus DNA-Molekülen nach Anspruch 2, bei dem das Codieren das Auswählen von DNA-Untersequenzen, die so gewählt sind, daß sie durch Restriktionsabbildung eindeutig unterscheidbar sind, umfaßt.

**6.** Verfahren zum Schreiben in einen und zum Lesen aus einem Assoziativspeicher aus DNA-Molekülen nach Anspruch 2, bei dem das Codieren das Auswählen natürlich auftretender DNA-Fragmente umfaßt.

**7.** Verfahren zum Schreiben in einen und zum Lesen aus einem Assoziativspeicher aus DNA-Molekülen nach Anspruch 2, bei dem das Codieren das Anhängen einer Stoppsequenz an eine Sequenz, der eine vorgegebene, einen vorgegebenen Wert besitzende Komponente eines Vektors zugeordnet ist, umfaßt.

**8.** Verfahren zum Schreiben in einen und zum Lesen aus einem Assoziativspeicher aus DNA-Molekülen nach Anspruch 2, bei dem das Codieren das Anhängen einer Startsequenz und einer Stoppsequenz an eine Sequenz, der eine vorgegebene, einen vorgegebenen Wert besitzende Komponente eines Vektors zugeordnet ist, umfaßt.

**9.** Verfahren zum Schreiben in einen und zum Lesen aus einem Assoziativspeicher aus DNA-Molekülen nach Anspruch 2, wobei der vorgegebene Wert aus der Gruppe gewählt ist, die aus "1"en, "0"en und "1"en und "0"en besteht.

**10.** Verfahren zum Schreiben in einen und zum Lesen aus einem Assoziativspeicher aus DNA-Moleküle nach einem der Ansprüche 1 oder 2, wobei das Durchsuchen das Markieren vorgegebener Untersequenzen aus einem DNA-Molekül und das Extrahieren markierter Moleküle umfaßt.

11. Verfahren zum Schreiben in einen und zum Lesen aus einem Assoziativspeicher aus DNA-Molekülen nach Anspruch 10, wobei das Markieren das Zuordnen magnetischer Ränder umfaßt und das Extrahieren die magnetische Separation umfaßt.

12. Verfahren zum Schreiben in einen und zum Lesen aus einem Assoziativspeicher aus DNA-Molekülen nach einem der Ansprüche 1 oder 2, wobei das Durchsuchen das Einführen einer DNA mit einer zu den vorgegebenen Untersequenzen komplementären Untersequenz umfaßt.

13. Assoziativspeicher, mit:

kundenspezifischen DNA-Molekülen, die mit Informationen codiert sind, wobei die Moleküle in einem Gefäß angeordnet sind;
einer Einrichtung zum Durchsuchen der kundenspezifischen DNA-Moleküle nach jenen Molekülen mit einer vorgegebenen Untersequenz; und
einer Einrichtung zum Auslesen jener Moleküle mit einer vorgegebenen Untersequenz.

14. Assoziativspeicher nach Anspruch 13, wobei die Einrichtung zum Durchsuchen das Einleiten eines markierten DNA-Moleküls mit einer zu der vorgegebenen Untersequenz komplementären Sequenz umfaßt.

15. Assoziativspeicher nach Anspruch 14, wobei die Markierung ein magnetischer Rand ist.

16. Assoziativspeicher nach Anspruch 13, wobei die codierten Informationen einen Adressenabschnitt und einen Datenabschnitt umfassen.

17. Assoziativspeicher nach Anspruch 13, wobei die Einrichtung zum Lesen ein Restriktionsenzym umfaßt.

**Revendications**

1. Méthode d'écriture dans et de lecture depuis une mémoire associative de molécules d'ADN, comprenant les étapes de :

- formation de molécules d'ADN particularisées codées avec des informations ;
- mise en place desdites molécules d'ADN particularisées dans un récipient ;
- recherche, dans lesdites molécules d'ADN particularisées, des molécules ayant une sous-séquence prédéterminée et sélection desdites molécules ayant la sous-séquence prédéterminée ; et
- lecture des molécules d'ADN sélectionnées.

2. Méthode d'écriture dans et de lecture depuis une mémoire associative de molécules d'ADN selon la revendication 1, où ladite formation de molécules d'ADN particularisées comprend le codage de composantes d'un vecteur pour un mot mémorisé qui ont une valeur prédéterminée.

3. Méthode d'écriture dans et de lecture depuis une mémoire associative de molécules d'ADN selon la revendication 2, où ledit codage comprend la concaténation de sous-séquences correspondant à un vecteur ayant une valeur prédéterminée à une composante prédéterminée.

4. Méthode d'écriture dans et de lecture depuis une mémoire associative de molécules d'ADN selon la revendication 2, où ledit codage comprend la sélection de sous-séquences d'ADN contenant un code optimisé.

5. Méthode d'écriture dans et de lecture depuis une mémoire associative de molécules d'ADN selon la revendication 2, où ledit codage comprend la sélection de sous-séquences d'ADN choisies pour être faciles à distinguer de façon non ambiguë par cartographie de restriction.

6. Méthode d'écriture dans et de lecture depuis une mémoire associative de molécules d'ADN selon la revendication 2, où ledit codage comprend la sélection de fragments d'ADN se trouvant dans la nature.

7. Méthode d'écriture dans et de lecture depuis une mémoire associative de molécules d'ADN selon la revendication 2, où ledit codage comprend l'ajout d'une séquence d'arrêt à une séquence associée à une composante prédéterminée d'un vecteur ayant une valeur prédéterminée.

8. Méthode d'écriture dans et de lecture depuis une mémoire associative de molécules d'ADN selon la revendication 2, où ledit codage comprend l'ajout d'une séquence de départ et d'une séquence d'arrêt à une séquence associée à une composante prédéterminée d'un vecteur ayant une valeur prédéterminée.

9. Méthode d'écriture dans et de lecture depuis une mémoire associative de molécules d'ADN selon la revendication 2, où ladite valeur prédéterminée est sélectionnée dans le groupe consistant en "1", en "0", et en "1" et "0".

**10.** Méthode d'écriture dans et de lecture depuis une mémoire associative de molécules d'ADN selon la revendication 1 ou 2, où ladite recherche comprend le marquage de sous-séquences prédéterminées d'une molécule d'ADN et l'extraction de molécules marquées.

**11.** Méthode d'écriture dans et de lecture depuis une mémoire associative de molécules d'ADN selon la revendication 10, où ledit marquage comprend l'association de perles magnétiques et ladite extraction comprend une séparation magnétique.

**12.** Méthode d'écriture dans et de lecture depuis une mémoire associative de molécules d'ADN selon la revendication 1 ou 2, où ladite recherche comprend l'introduction d'ADN ayant une sous-séquence complémentaire auxdites sous-séquences prédéterminées.

**13.** Mémoire associative comprenant :

- des molécules d'ADN particularisées codées avec des informations, lesdites molécules étant disposées dans un récipient ;
- des moyens de recherche, dans lesdites molécules d'ADN particularisées, des molécules ayant une sous-séquence prédéterminée ; et
- des moyens de lecture des molécules ayant une sous-séquence prédéterminée.

**14.** Mémoire associative selon la revendication 13, où lesdits moyens de recherche comprennent l'introduction d'une molécule d'ADN marquée avec une sous-séquence complémentaire à ladite sous-séquence prédéterminée.

**15.** Mémoire associative selon la revendication 14, où ledit marqueur est une perle magnétique.

**16.** Mémoire associative selon la revendication 13, où lesdites informations codées comprennent une partie d'adresse et une partie de données.

**17.** Mémoire associative selon la revendication 13, où lesdits moyens de lecture comprennent une enzyme de restriction.

Forming custom DNA molecule
and placing molecule in
vessel

10

Searching vessel for DNA
molecule having a
predetermined subsequence
or several predetermined
subsequences

20

Reading out remainder of
DNA molecule

30

Fig. 1